## Europäisches Patentamt

## European Patent Office

## Office européen des brevets

(11) Veröffentlichungsnummer: **0 135 120 B1**

(12) **EUROPÄISCHE PATENTSCHRIFT**

(45) Veröffentlichungstag der Patentschrift:
09.03.88

(21) Anmeldenummer: **84109466.7**

(22) Anmeldetag: **09.08.84**

(51) Int. Cl.⁴: **H 01 L 23/14, H 01 L 23/36**

(54) **Keramik-Metall-Element.**

(30) Priorität: **23.08.83 CH 4581/83**

(43) Veröffentlichungstag der Anmeldung:
**27.03.85 Patentblatt 85/13**

(45) Bekanntmachung des Hinweises auf die Patenterteilung:
**09.03.88 Patentblatt 88/10**

(84) Benannte Vertragsstaaten:
**CH DE FR GB IT LI NL SE**

(56) Entgegenhaltungen:
**EP - A - 0 057 085**
**DE - A - 3 221 199**

**PATENTS ABSTRACTS OF JAPAN, Band 6, Nr. 12(E-91(890), 23. Januar 1982**
**IBM TECHNICAL DISCLOSURE BULLETIN, Band 20, Nr. 11B, April 1978, Seiten 4783-4784, New York, USA; C.S. CHANG et al.: "Porcelain copper card with multiple power planes"**
**"Journal of the American Ceramic Society" Vol. 65, No. 3, 1982, Seiten 149-153**

(73) Patentinhaber: **BBC Brown Boveri AG, CH-5401 Baden (CH)**

(72) Erfinder: **Gobrecht, Jens, Dr., Birchhofstrasse 6, CH-5412 Gebenstorf (DE)**

ACTORUM AG

## Beschreibung

Die Erfindung betrifft ein Keramik-Metall-Element gemäss dem Oberbegriff des Anspruchs 1.

Ein solches im sogenannten «direct-bonding»-Verfahren hergestelltes Keramik-Metall-Element ist beispielsweise bekannt aus einem Artikel von A. Neidig in den BBC-Nachrichten (1982), Heft 7, Seiten 196 bis 200. Es findet dort Verwendung zum Aufbau von hybrid-integrierten Leistungs-Halbleiterbauelementen in standardisierten Kompaktgehäusen. Bei dieser Verwendung ist das Keramiksubstrat auf seiner der Metallschicht abgewandten Seite mit Leiterbahnen versehen. Auf den Leiterbahnen sind aktive Halbleiterelemente wie Thyristoren oder Dioden sowie Steckkontakte aufgebracht. Die in den aktiven Halbleiterelementen im Betrieb anfallende Verlustwärme wird durch das Keramiksubstrat und die Metallschicht zu einem Kühlkörper abgeführt, auf welchen das Keramik-Metall-Element eben aufgesetzt ist. Die Metallschicht soll dabei einen guten Wärmekontakt zwischen Keramiksubstrat und Kühlkörper herstellen.

Bei dem bekannten Halbleiterbauelement ist die Dicke der Metallschicht erheblich geringer als die Dicke des Keramiksubstrats und entspricht etwa der Dicke der Leiterbahnen. Zur Verbesserung der Wärmeabfuhr von den aktiven Halbleiterelementen zum Kühlkörper und damit zur Verbesserung der thermischen Belastbarkeit der aktiven Halbleiterelemente ist es wünschenswert, die Metallschicht dicker, dicker noch als das Keramiksubstrat zu machen. Letzteres sollte dabei möglichst dünn sein. Dies ist mit herkömmlicher Technik nicht möglich. Wie aus einem Artikel von M. Wittmer et. al. in «Journal of the American Ceramic Society» Vol. 65, No. 3, 1982, Seiten 149–153 hervorgeht, ergibt sich aufgrund der beim «direct-bonding»-Verfahren erforderlichen hohen Verbindungstemperatur (von etwa 1070°C für Cu als Metall und $Al_2O_3$ als Keramik) und der unterschiedlichen thermischen Ausdehnungskoeffizienten der bei den Materialien Metall und Keramik nach der Abkühlung von der Verbindungstemperatur auf Umgebungstemperatur eine mit der Dicke der Metallschicht zunehmende Krümmung des Keramikmetallelements nach Art einer bimetallischen Krümmung. Übersteigt die Dicke der Metallschicht die Dicke des Keramiksubstrats, so ist mit einem Brechen des Keramiksubstrats zu rechnen.

Aufgabe der Erfindung ist es daher, ein Keramik-Metall-Element der eingangs genannten Art zu schaffen, bei welchem die Metallschicht eine wenigstens annähernd gleiche oder grössere Dicke als das Keramiksubstrat aufweist. Dabei darf das Keramiksubstrat während der Abkühlung des Keramik-Metall-Elements von der Verbindungstemperatur auf die Umgebungstemperatur weder brechen noch darf das Keramik-Metall-Element nach der Abkühlung eine Krümmung aufweisen. Diese Aufgabe wird erfindungsgemäss gelöst durch die Merkmale des Anspruchs 1.

Die erfindungsgemässe Lösung besteht also in einer Strukturierung der Metallschicht, insbesondere in ihrem mosaikartigen Aufbau aus vielen kleinen Metallelementen, deren laterale Abmessungen etwa der Dicke der Metallschicht entsprechen. Dadurch wird – durch eine gewisse Umverteilung der Zugspannungen in der Metallschicht auf Scherspannungen – ein Brechen des Keramiksubstrats sowie eine Krümmung des gesamten Keramik-Metall-Elements in vorteilhafter Weise vermieden. Für die beschriebene Verwendung des Keramik-Metall-Elements zum Aufbau von hybrid-integrierten Leistungs-Halbleiterbauelementen stellt die Strukturierung der Metallschicht keinen Nachteil dar, da die Verlustwärme in der Metallschicht nur senkrecht zur Schichtebene abgeführt werden muss und auf eine laterale thermische Leitfähigkeit, d.h. eine Leitfähigkeit in der Ebene der Metallschicht verzichtet werden kann.

Weitere Vorteile sowie Merkmale der Erfindung, wie sie auch in den Unteransprüchen gekennzeichnet sind, ergeben sich aus der nachstehenden Beschreibung eines Ausführungsbeispiels, wobei auf die beigefügten Zeichnungen Bezug genommen wird.

Es zeigt:

Fig. 1 im Schnitt ein Keramik-Metall-Element mit nicht strukturierter Metallschicht bei Verbindungstemperatur,

Fig. 2 ebenfalls im Schnitt das Keramik-Metall-Element nach Fig. 1 nach Abkühlung auf Umgebungstemperatur,

Fig. 3 in perspektivischer Darstellung ein Keramik-Metall-Element nach der Erfindung mit strukturierter Metallschicht nach bereits erfolgter Abkühlung auf Umgebungstemperatur,

Fig. 4 eine Aufsicht auf eine durch eingestanzte Schlitze strukturierte Metallschicht,

Fig. 5 das Keramik-Metall-Element nach Fig. 3 in einem Schnitt entlang A-A mit der Darstellung eines Belags auf den Metallelementen der Metallschicht und

Fig. 6 in perspektivischer Darstellung das Keramik-Metall-Element nach den Fig. 3 und 4 ausgebildet als hybrid-integriertes Leistungs-Halbleiterbauelement, aufgesetzt auf einen Kühlkörper.

In den Figuren sind übereinstimmende Teile mit übereinstimmenden Bezugszeichen versehen.

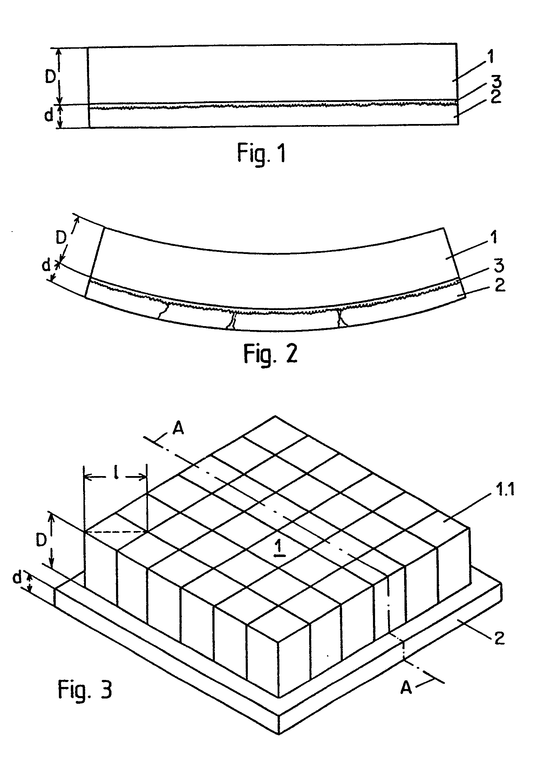

In Fig. 1 ist in einem Schnitt ein Keramik-Metall-Element mit einer Metallschicht 1 und einem Keramiksubstrat 2 dargestellt. Die Metallschicht 1 ist durchgehend und nicht strukturiert. Das Metall der Metallschicht 1 ist vorzugsweise Cu und die Keramik $Al_2O_3$, doch können auch andere Metalle wie Al und andere Oxydkeramiken wie z.B. BeO, AlN oder SiC verwendet sein. Die Metallschicht 1 weist zumindest auf ihrer dem Keramiksubstrat 2 zugewandten Seite eine oberflächliche Oxydschicht 3 auf, bei Verwendung von Cu für die Metallschicht 1 eine CuO-Schicht. Das Keramik-Metall-Element nach Fig. 1 soll eine vorstehend bereits als Verbindungstemperatur bezeichnete Temperatur – für $Al_2O_3$ und Cu etwa 1070°C – aufweisen. Die Verbindungstemperatur soll oberhalb derjenigen Temperatur liegen, bei welcher sich zwischen der Oxydschicht 3 und einem Teil des reinen Metalls der Metallschicht 1 ein flüssiges Eutektikum ausbildet – für CuO und Cu etwa 1060°C. Das Eutektikum ist die eingangs erwähnte flüssige, eutektische Zwischenschicht. Andererseits darf die Verbindungstemperatur auch nicht höher sein als die Schmelztemperatur des reinen Metalls der Metallschicht 1 – für Cu 1083°C. Die flüssige, eutektische Zwischenschicht zwischen der Metallschicht 1 und dem Keramiksubstrat 2 hat die Eigenschaft, die Oberfläche des Keramiksubstrats 2 zu benetzen und sogar in feinste Poren des Keramiksubstrats 2 einzudringen. Bei Abkühlung des Keramik-Metall-Elementes auf den Schmelzpunkt der eutektischen Zwischenschicht verfestigt sich diese und bildet eine feste Verbindung zwischen der Metallschicht 1 und dem Keramiksubstrat 2. Bei weiterer Abkühlung des Keramik-Metall-Elementes, letztlich bis auf Umgebungstemperatur, d.h. auf etwa 20°C, treten aufgrund der stark unterschiedlichen thermischen Ausdehnungskoeffizienten des Metalls und der Keramik sowohl in der Metallschicht 1 als auch im Keramiksubstrat 2 hohe Zugspannungen auf. Diese haben zumindest eine mit der Dicke der Metallschicht 1 zunehmende, bleibende Krümmung des Keramik-Metall-Elementes zur Folge oder führen gar, insbesondere wenn die Dicke der Metallschicht 1 die Dicke des Keramiksubstrats 2 übersteigt, zu einem Brechen der Keramik. In den Figuren ist die Dicke der Metallschicht 1 mit D, die Dicke des Keramiksubstrats 2 mit d bezeichnet.

In Fig. 2 ist das Keramik-Metall-Element nach Fig. 1 nach seiner Abkühlung auf Umgebungstemperatur mit einer ausgeprägten Krümmung sowie Rissen im Keramiksubstrat 2 dargestellt.

Fig. 3 zeigt in perspektivischer Darstellung ein Keramik-Metall-Element nach der Erfindung mit einer strukturierten Metallschicht 1. Die Metallschicht 1 ist aus vielen einzelnen Metallelementen 1.1 mosaikartig zusammengesetzt. Die Metallelemente 1.1 haben wenigstens überwiegend keine gegenseitige feste Verbindung, sondern grenzen lose aneinander. Das erfindungsgemässe Keramik-Metall-Element weist bereits Umgebungstemperatur auf. Durch die Strukturierung der Metallschicht 1 wird eine Umlenkung von Zugspannungen auf Scherspannungen in der Metallschicht 1 erreicht, wodurch eine Krümmung des Keramik-Metall-Elementes oder ein Brechen des Keramiksubstrats 2 bei der Abkühlung von der Verbindungstemperatur auf die Umgebungstemperatur sicher vermieden wird. Die Metallelemente 1.1 können an sich beliebige Formen haben, sofern sie sich nur mosaikartig zu einer einigermassen geschlossenen Metallschicht 1 zusammenfügen lassen. Als Formen für die Metallelemente 1.1 eignen sich besonders Quader- oder Sechskantstäbe. Als äquivalent zum mosaikartigen Aufbau der Metallschicht 1 aus einzelnen Elementen ist anzusehen, eine einheitliche Metallschicht 1 durch eingestanzte Schlitze oder eingebrachte Löcher zu strukturieren, so dass die einzelnen Elemente noch durch Metallbrücken zusammenhängen.

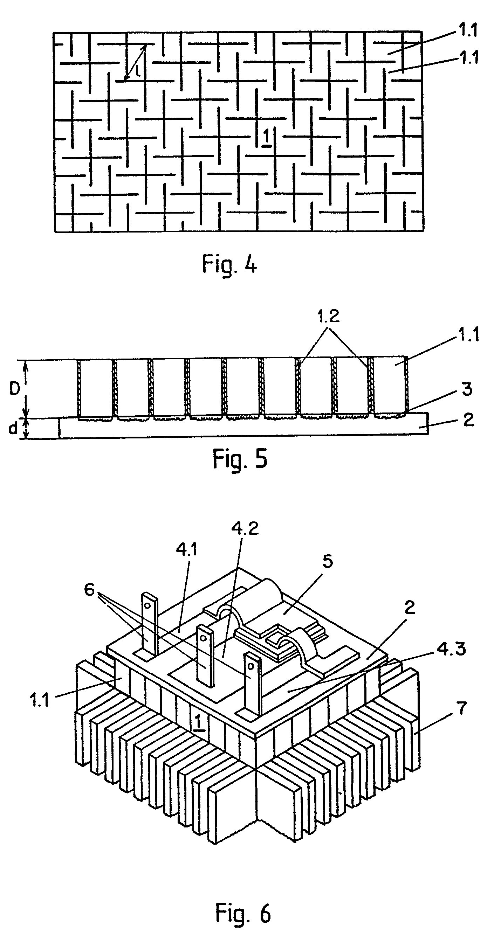

Fig. 4 zeigt eine Aufsicht auf eine derart durch eingestanzte, sich überkreuzende Schlitze strukturierte Metallschicht 1. Wesentlich bei der Strukturierung der Metallschicht 1 bzw. ihrem mosaikartigen Aufbau ist, dass die grösste lineare Ausdehnung der Metallelemente 1.1 in der Schichtebene, in Fig. 3 und 4 mit I bezeichnet, kleiner oder zumindest nicht viel grösser als die doppelte Dicke D der Metallschicht 1 ist. Vorzugsweise ist die grösste lineare Ausdehnung I der Metallelemente 1.1 etwa gleich ihrer Dicke D. Es können sich dann in den Metallelementen 1.1 keine ausreichend grossen Zugspannungen aufbauen, welche eine Krümmung des Keramik-Metall-Elementes oder ein Brechen des Keramiksubstrats 2 verursachen könnten.

Ohne besondere Behandlung sind die Metallelemente 1.1 nicht nur auf ihrer dem Keramiksubstrat 2 zugewandten Seite, sondern auf ihrer gesamten Oberfläche mit einer Oxydschicht versehen. Bei Verbindungstemperatur sind die Metallelemente 1.1 dann vollständig von einer eutektischen Schicht überzogen und können an ihren gegenseitigen Berührungsflächen miteinander verschmelzen und nach Abkühlung eine feste Verbindung miteinander eingehen. Ein solches Verschmelzen kann durch einen, auf den gegenseitigen Berührungsflächen der Metallelemente 1.1 aufgebrachten Belag, in Fig. 5 mit 1.2 bezeichnet, verhindert werden. Der Belag muss eine Schmelztemperatur oberhalb der Verbindungstemperatur, besser noch oberhalb der Schmelztemperatur des Metalls der Metallelemente 1.1 aufweisen. Als Material für den Belag 1.2 eignet sich z.B. Ni, Pd, Pt oder Cr. Der Belag 1.2 kann galvanisch oder in einem electroless-Verfahren, d.h. durch einfaches Eintauchen in einen Elektrolyten aufgebracht werden.

Fig. 6 zeigt das Keramik-Metall-Element nach Fig. 3 oder Fig. 5 in einer bevorzugten Anwendung zum Aufbau eines hybrid-integrierten Leistungs-Halbleiterbauelements. Dazu ist die der Metallschicht 1 abgewandte Seite des Keramiksubstrats 2 mit Leiterbahnen 4.1, 4.2 und 4.3 versehen. Die Leiterbahnen 4.1, 4.2 und 4.3 sind Metallfolien, welche, wie die Metallschicht 1, nach Abkühlung und dadurch verursachter Verfestigung einer zuvor eutektischen Zwischenschicht mit dem Keramiksubstrat 2 fest verbunden sind. Auf der Leiterbahn 4.2 ist ein aktives Halbleiterelement 5, z.B. ein Thyristor, mit seiner Anode nach unten aufgebracht. Zwischen der Leiterbahn 4.2 und dem Thyristor 5 kann zum Ausgleich thermischer Spannungen noch eine Molybdänscheibe angeordnet sein. Von der Leiterbahn 4.1 führt eine Kontaktbrücke zur Kathode des Thyristors 5 und von der Leiterbahn 4.3 eine Kontaktbrücke zu seinem Zündgate. Weiter sind auf den Leiterbahnen 4.1, 4.2 und 4.3 noch Steckkontakte 6 aufgelötet, auf welche ein Mehrfachstecker zur Kontaktierung des Thyristors 5 aufsteckbar ist. Die Leiterbahnen 4.1, 4.2 und 4.3 sowie der Thyristor 5 sind nur stellvertretend für eine grössere Zahl von Leiterbahnen bzw. aktiven Halbleiterelementen dargestellt, welche zum Aufbau eines vollständigen hybrid-integrierten Leistungs-Halb-leiterbauelements erforderlich sind. Das Bauele-ment nach Fig. 6 kann von einem nicht dargestellten Gehäuse umschlossen sein, aus welchem beispielsweise die Steckkontakte 6 herausragen. Zur Kühlung ist das beschriebene Bauelement schliesslich mit der Metallschicht 1 auf einen Kühlkörper 7 aufgesetzt. Die Metallschicht 1 wirkt dabei als ideale Wärmesenke, welche die im Thyristor 5 anfallende Verlustwärme nicht nur schnell aufnehmen, sondern auch noch schnell an den Kühlkörper weiterleiten kann.

## Patentansprüche

1. Keramik-Metall-Element bei welchem eine Metallschicht (1) mit einem Keramiksubstrat (2) nach Abkühlung und dadurch verursachter Verfestigung einer zuvor flüssigen eutektischen Zwischenschicht (3) fest verbunden ist, dadurch gekennzeichnet, dass die Metallschicht (1) eine wenigstens annähernd gleiche oder grössere Dicke (D) als das Keramiksubstrat (2) aufweist und mosaikartig aus einzelnen, überwiegend lose anein-andergrenzenden Metallelementen (1.1) zusam-mengesetzt ist und dass die grösste lineare Ausdehnung (1) der Metallelemente (1.1) in der Schichtebene der Metallschicht (1) kleiner oder zumindest nicht wesentlich grösser als die doppelte Dicke der Metallschicht (1) ist.

2. Keramik-Metall-Element nach Anspruch 1, dadurch gekennzeichnet, dass die grösste lineare Ausdehnung (1) der Metallelemente (1.1) in der Schichtebene der Metallschicht (1) gleich der einfachen Dicke (D) der Metallschicht ist.

3. Keramik-Metall-Element nach einem der Ansprüche 1 oder 2, dadurch gekennzeichnet, dass das Metall Cu oder Al und die Keramik Al₂O₃, BeO, AlN oder SiC ist.

4. Keramik-Metall-Element nach einem der Ansprüche 1 bis 3, dadurch gekennzeichnet, dass die Metallelemente (1.1) auf ihren gegenseitigen Berührungsflächen mit einem Belag (1.2) versehen sind, welcher bei Temperaturen unterhalb des Schmelzpunktes des Metalls kein Eutektikum bildet.

5. Keramik-Metall-Element nach Anspruch 4, dadurch gekennzeichnet, dass als Belag (1.2) Ni, Pd, Pt oder Cr verwendet ist.

6. Keramik-Metall-Element nach einem der Ansprüche 4 oder 5, dadurch gekennzeichnet, dass der Belag (1.2) galvanisch oder durch ein electroless-Verfahren auf den Metallelementen (1.1) aufgebracht ist.

7. Keramik-Metall-Element nach einem der Ansprüche 1 bis 6, dadurch gekennzeichnet, dass die Metallelemente (1.1) quaderförmig sind.

8. Keramik-Metall-Element nach einem der Ansprüche 1 bis 6, dadurch gekennzeichnet, dass die Metallelemente (1.1) Sechskantstäbe sind.

9. Keramik-Metall-Element nach einem der Ansprüche 1 bis 8, dadurch gekennzeichnet, dass das Keramiksubstrat (2) auf seiner der ersten Metallschicht (1) abgewandten Seite mit Leiterbahnen (4.1, 4.2, 4.3) versehen ist.

10. Keramik-Metall-Element nach Anspruch 9, dadurch gekennzeichnet, dass auf mindestens einer der Leiterbahnen (4.1, 4.2, 4.3) ein aktives Halbleiterelement (5) und/oder ein Steckkontakt (6) aufgebracht ist.

## Claims

1. Ceramic-metal element in which a metal layer (1) is firmly joined to a ceramic substrate (2) after cooling and solidification caused thereby of a previously liquid eutectic intermediate layer (3), characterized in that the metal layer (1) has an at least approximately equal or greater thickness (D) than the ceramic substrate (2) and is made up in a mosaic manner from individual metal elements (1.1) predominantly adjacent to each other in an unattached manner, and in that the largest linear dimension (1) of the metal elements (1.1) in the plane of the layer of the metal layer (1) is less than, or at least not appreciably greater than, double the thickness of the metal layer (1).

2. Ceramic-metal element according to claim 1, characterized in that the largest linear dimension (1) of the metal elements (1.1) in the planes of the metal layer (1) is equal to the single thickness (D) of the metal layer.

3. Ceramic-metal element according to one of the claims 1 or 2, characterized in that the metal is Cu or Al and the ceramic is Al₂O₃, BeO, AlN or SiC.

4. Ceramic-metal element according to one of the claims 1 to 3, characterized in that the metal elements (1.1) are provided on their mutual contact surfaces with a coating (1.2) which does not form an eutectic at temperatures below the melting point of the metal.

5. Ceramic-metal element according to claim 4, characterized in that Ni, Pd, Pt or Cr is used as coating (1.2).

6. Ceramic-metal element according to one of the claims 4 or 5, characterized in that the coating (1.2) is deposited on the metal elements (1.1) by electroplating or by an electroless process.

7. Ceramic-metal element according to one of the claims 1 to 6, characterized in that the metal elements (1.1) are of cuboid shape.

8. Ceramic-metal element according to one of the claims 1 to 6, characterized in that the metal elements (1.1) are hexagonal rods.

9. Ceramic-metal elements according to one of the claims 1 to 8, characterized in that the ceramic substrate (2) is provided with conductor tracks (4.1, 4.2, 4.3) on the side of it facing away from the first metal layer (1).

7 0 135 120 8

10. Ceramic-metal element according to claim 9, characterized in that an active semiconductor element (5) and/or plug contact (6) is mounted on at least one of the conductor tracks (4.1, 4.2, 4.3).

**Revendications**

1. Elément céramique-métallique dans lequel une couche métallique (1) est solidement liée à un substrat céramique (2) après refroidissement et solidification résultante d'une couche intermédiaire (3) eutectique préalablement liquide, caractérisé en ce que la couche métallique (1) présente une épaisseur (D) au moins environ égale ou supérieure à celle du substrat céramique (2) et est composée d'une mosaïque d'éléments métalliques individuels (1.1) librement juxtaposés et en ce que la plus grande dimension linéaire (I) des éléments métalliques (1.1) dans le plan de la couche métallique (1) est inférieure ou au moins n'est pas upérieure de beaucoup au double de l'épaisseur de la couche métallique (1).

2. Elément céramique-métallique suivant la revendication 1, caractérisé en ce que la plus grande dimension linéaire (I) des éléments métalliques (1.1) dans le plan de la couche métallique (1) est égale à une fois l'épaisseur (D) de la couche métallique.

3. Elément céramique-métallique suivant l'une des revendications 1 ou 2, caractérisé en ce que le métal est le Cu ou Al et la céramique $Al_2O_3$, BeO, AIN ou SiC.

4. Elément céramique-métallique suivant une des revendications 1 à 3, caractérisé en ce que les éléments métalliques (1.1) sont pourvus sur leurs faces de contact opposées d'un revêtement (1.2) qui ne forme pas d'eutectique à des températures inférieures au point de fusion du métal.

5. Elément céramique-métallique suivant la revendication 4, caractérisé en ce que le revêtement (1.2) utilisé est constitué de Ni, Pd, Pt ou Cr.

6. Elément céramique-métallique suivant l'une des revendications 4 ou 5, caractérisé en ce que le revêtement (1.2) est déposé par voie galvanique ou par un procédé electroless sur les éléments métalliques (1.1).

7. Elément céramique-métallique suivant l'une des revendications 1 à 6, caractérisé en ce que les éléments métalliques (1.1) sont carrés.

8. Elément céramique-métallique suivant l'une des revendications 1 à 6, caractérisé en ce que les éléments métalliques (1.1) sont des barreaux hexagonaux.

9. Elément céramique-métallique suivant l'une des revendications 1 à 8, caractérisé en ce que le substrat céramique (2) est pourvu de voies conductrices (4.1, 4.2, 4.3) sur sa face située à l'opposé de la première couche métallique (1).

10. Elément céramique-métallique suivant la revendication 9, caractérisé en ce qu'un composant semiconducteur actif (5) et/ou un contact à fiches (6) est monté sur au moins une des voies conductrices (4.1, 4.2, 4.3).

Fig. 1

Fig. 2

Fig. 3

Fig. 4

Fig. 5

Fig. 6